# EUROPEAN PATENT APPLICATION

(11) **EP 4 471 534 A1**
(43) Date of publication of application: **04.12.2024**
(21) Application number: 23195860.4
(22) Date of filing: 07.09.2023
(51) Int. Cl.: G06F 1/16, H04M 1/02

(54) **HINGE AND FOLDABLE DISPLAY DEVICE**

(30) Priority: 31.05.2023 CN 202310637456
(71) Applicant: Beijing Xiaomi Mobile Software Co., Ltd., Beijing 100085 (CN)
(72) Inventor: LIU, Xinwei, Beijing, 100085 (CN)
(74) Representative: dompatent von Kreisler Selting Werner - Partnerschaft von Patent- und Rechtsanwälten mbB

(57) **Abstract**

A hinge (000) includes: a supporting base (100) extending in a first direction (X); and at least two flip parts (200), each flip part (200) being rotatably connected to the supporting base (100), in which the at least two flip parts (200) are configured to be distributed on two opposite sides of the supporting base (100) in a second direction (Y) in case that the hinge (000) is in an unfolded state, and the second direction (Y) intersects with the first direction (X). Each of the at least two flip parts (200) includes a first rotating member (201), and a first connecting portion (202) connected to a first end of the first rotating member (201). The supporting base (100) has a first arc-shaped sliding groove (C1), and a part of the first connecting portion (202) is located in the first arc-shaped sliding groove (C1).

## Description

### TECHNICAL FIELD

The present invention relates to a field of electronic devices, and more particularly to a hinge and a foldable display device.

### BACKGROUND

With development of display technology, more and more display devices are equipped with a foldable display screen. The display device equipped with the foldable display screen may achieve flexible size-switching of the display device, thus greatly improving the user experience.

Currently, a foldable display device may generally include: a housing, a flexible display panel, and a hinge for folding the flexible display panel. The hinge is fixed in the housing, and a back of the flexible display panel may be fixedly connected to the housing. The hinge may drive the flexible display panel to be folded or unfolded through the housing in case that the hinge rotates, and finally the foldable display device can be in a folded state or an unfolded state.

However, the hinge in the current foldable display device has a low reliability, resulting in a low reliability of the foldable display device.

### SUMMARY

Embodiments of the present invention provide a hinge and a foldable display device, which can solve a problem that the foldable display device in the related art has a low reliability, and the technical solution is as follows.

According to a first aspect, there is provided a hinge, and the hinge includes: a supporting base extending in a first direction; and at least two flip parts, in which each flip part is rotatably connected to the supporting base, and the at least two flip parts are configured to be distributed on two opposite sides of the supporting base in a second direction in case that the hinge is in an unfolded state, and the second direction intersects the first direction. The flip part includes: a first rotating member, and a first connecting portion connected to a first end of the first rotating member; and the supporting base has a first arc-shaped sliding groove, and a part of the first connecting portion is located in the first arc-shaped sliding groove.

Optionally, the supporting base further includes a first hollowed-out groove, and the first arc-shaped sliding groove is in communication with the first hollowed-out groove; and the first end of the first rotating member is located in the first hollowed-out groove, and is rotatably connected to the supporting base through the first connecting portion.

Optionally, each of the at least two flip parts further includes: a rotating assembly, a first end of the rotating assembly is rotatably connected to the supporting base, and a second end of the rotating assembly is slidably connected to a second end of the first rotating member.

Optionally, the hinge further includes a synchronizing mechanism connected respectively to two flip parts located on the two opposite sides of the supporting base, respectively.

Optionally, the synchronizing mechanism includes: two first synchronizing members rotatably connected to the first ends of the two rotating assemblies respectively, and the two first synchronizing members are connected to each other.

Optionally, the first end of the rotating assembly has a second rotating member; and the supporting base further includes a second hollowed-out groove, and a sliding portion located in the second hollowed-out groove, and the second rotating member is located in the second hollowed-out groove and rotatably connected to the sliding portion.

Optionally, the first synchronizing member includes: a first shaft, and a roller fitted over the first shaft and fixedly connected to the first shaft, and the roller is connected to the second rotating member.

Optionally, the second rotating member includes a second connecting portion and a third connecting portion, a surface of the second connecting portion and a surface of the third connecting portion enclose a second arc-shaped sliding groove, and at least part of the sliding portion is located in the second arc-shaped sliding groove.

Optionally, the second connecting portion includes a first section and a second section; and the first section and the second section are disposed side by side, the first section is connected to the third connecting portion, and a surface of the first section and the surface of the third connecting portion enclose the second arc-shaped sliding groove; and the roller is connected to the second section, and the first section and the second section are configured to slide relative to the sliding portion along the second arc-shaped sliding groove to drive the roller to rotate.

Optionally, a surface of the second connecting portion facing the roller is an arc-shaped surface; and an arc-shaped surface of the second section is frictionally connected to the roller; or, an arc-shaped surface of the second section has a meshing portion, and the second section is connected to the roller by the meshing portion.

Optionally, the arc-shaped surface is an arc-shaped concave surface; and the third connecting portion includes a body section and a protruding section, the body section has a first arc-shaped convex surface, the protruding section has a second arc-shaped convex surface coaxial with the first arc-shaped convex surface, the body section is bridged on the second connecting portion, the first arc-shaped convex surface abuts against the arc-shaped concave surface, and the arc-shaped concave surface and the second arc-shaped convex surface enclose the second arc-shaped sliding groove.

Optionally, the first synchronizing member further includes a first synchronizing wheel fitted over the first shaft and fixedly connected to the first shaft; and two first synchronizing wheels of the two first synchronizing members are synchronously connected to each other.

Optionally, the synchronizing mechanism includes a fixing member located between the two rotating assemblies, and the fixing member having a rolling part; and a side of the rotating assembly adjacent to the fixing member has a guide groove, and a part of the rolling part is located in the guide groove.

Optionally, the guide groove has a curve-shaped guiding direction.

Optionally, the flip part further includes a connecting shaft connected to the supporting base, and the connecting shaft is connected to a side of the rotating assembly adjacent to the fixing member; and the connecting shaft is configured to slide in the first direction relative to the supporting base, and/or, the rotating assembly is configured to slide in the first direction relative to the connecting shaft.

Optionally, the flip part further includes a fourth connecting portion connected to the second end of the first rotating member, and an axial direction of the fourth connecting portion is parallel to the first direction; and the second end of the rotating assembly has a sliding groove, and an end of the fourth connecting portion facing away from the first rotating member is located in the sliding groove and slidably connected to the rotating assembly.

Optionally, the hinge further includes a torsion part connected to the flip part, and the torsion part includes one or more friction plates; the one or more friction plates are arranged side by side in the first direction in at least one of following positions: between the first rotating member and the supporting base in any one of the flip parts; between the rotating assembly and the supporting base in any one of the flip parts; and between two adjacent flip parts.

Optionally, the torsion part further includes a transmission shaft connected to the flip part, and the one or more friction plates are fitted over the transmission shaft in the first direction.

Optionally, the supporting base includes a protective shell and a base body; and the protective shell is snap-fitted to the base body, and the base body is rotatably connected to the flip part.

Optionally, the at least two flip parts are arranged side by side in the first direction.

According to a second aspect, there is provided a foldable display device, and the foldable display device includes a flexible display panel, at least two housings and the above hinge of the first aspect of the present invention. The at least two housings are connected to each other through the hinge, and the flexible display panel is arranged on and covers the at least two housings.

The technical solutions according to the embodiments of the present invention at least include the following advantageous effects.

The hinge includes the supporting base and the at least two flip parts. The flip part includes the first rotating member, and the first connecting portion connected to the first end of the first rotating member, and a part of the first connecting portion is located in the first arc-shaped sliding groove in the supporting base. Since the first rotating member is connected to the supporting base through the first connecting portion, and the part of the first connecting portion may be located in the first arc-shaped sliding groove of the supporting base, the first connecting portion may be limited by the first arc-shaped sliding groove during the rotation of the first rotating member relative to the supporting base, so that the first rotating member connected to the first connecting portion will not fall off the supporting base, thus making the hinge more reliable, and hence improving the reliability of the foldable display device including the hinge.

### BRIEF DESCRIPTION OF THE DRAWINGS

In order to clearly illustrate technical solutions of embodiments of the present invention, a brief description of drawings used in embodiments is given below. Obviously, the drawings in the following descriptions are only part embodiments of the present invention, and for those skilled in the art, other drawings can be obtained according to these drawings without creative labor.
FIG. 1 is a schematic view of a hinge according to an embodiment of the present invention.
FIG. 2 is an exploded view of a flip part according to an embodiment of the present invention.
Fig. 3 is an exploded view of a hinge according to an embodiment of the present invention.
FIG. 4 is a partial schematic view of a hinge according to an embodiment of the present invention.
FIG. 5 is another partial schematic view illustrating a hinge according to an embodiment of the present invention.
FIG. 6 is a schematic view of fit between a rotating assembly and a base body according to an embodiment of the present invention.
FIG. 7 is a schematic view of a second synchronizing member according to an embodiment of the present invention.
FIG. 8 is a schematic view of a fixing member according to an embodiment of the present invention.
FIG. 9 is a schematic view of connection between a fixing member and a rotating assembly according to an embodiment of the present invention.
FIG. 10 is another schematic view of connection of a fixing member and a rotating assembly according to an embodiment of the present invention.
FIG. 11 is a schematic view of connection between a second end of a first rotating member and a second end of a rotating assembly according to an embodiment of the present invention.
FIG. 12 is a partial schematic view of another hinge according to an embodiment of the present invention.
FIG. 13 is a schematic view of each friction plate according to an embodiment of the present invention.
FIG. 14 is a schematic view of another hinge according to an embodiment of the present invention.

### DETAILED DESCRIPTION

In order for objects, solution and advantages of the present invention to become more apparent, embodiments of the present invention will be described in detail with reference to the accompanying drawings.

A hinge in a foldable display device generally includes: a supporting base, and at least two flip parts rotatably connected to the supporting base. The at least two flip parts are distributed on both sides of the supporting base in a width direction of the supporting base. For example, the at least two flip parts may be symmetrically distributed on both sides of the supporting base in the width direction of the supporting base. Each flip part may include: a driving rod. A first end of the driving rod has an arc-shaped plate, and a second end of the driving rod may be connected to a housing in the foldable display device. For example, the second end of the driving rod may be fixedly connected to the housing in the foldable display device. The supporting base may have an arc-shaped sliding groove matched in shape with the arc-shaped plate, the arc-shaped plate at the first end of the driving rod may be located in the arc-shaped sliding groove, and the arc-shaped plate may be connected to the supporting base in the arc-shaped sliding groove. For example, the arc-shaped plate may be rotatably connected to the supporting base in the arc-shaped sliding groove.

In this way, the housing in the foldable display device may drive the driving rod to rotate during the continuous folding or unfolding of the foldable display device, so that the arc-shaped plate at the first end of the driving rod can slide in the arc-shaped sliding groove, thus allowing the driving rod to rotate relative to the supporting base.

Since a flexible display panel in the foldable display device tends to move outwards relative to the supporting base during unfolding of the foldable display device, it is preferred for the housing to also move outwards relative to the supporting base so as to ensure that the housing does not pull the flexible display panel in this process. In this way, in the process that the arc-shaped plate at the first end of the driving rod slides in the arc-shaped sliding groove, it is preferred for a rotation axis of the arc-shaped plate to be located outside the supporting base, and also to have a certain distance from the supporting base. However, in case that the rotation axis of the arc-shaped plate is arranged in this way, the arc-shaped plate tends to slide out of the arc-shaped sliding groove, thus causing the driving rod to fall off the supporting base, and hence resulting in low reliability of the hinge. However, in order to prevent the arc-shaped plate from sliding out of the arc-shaped sliding groove, an additional limiting structure needs to be arranged at a joint of the driving rod and the supporting base, which will lead to a complicated structure of the hinge.

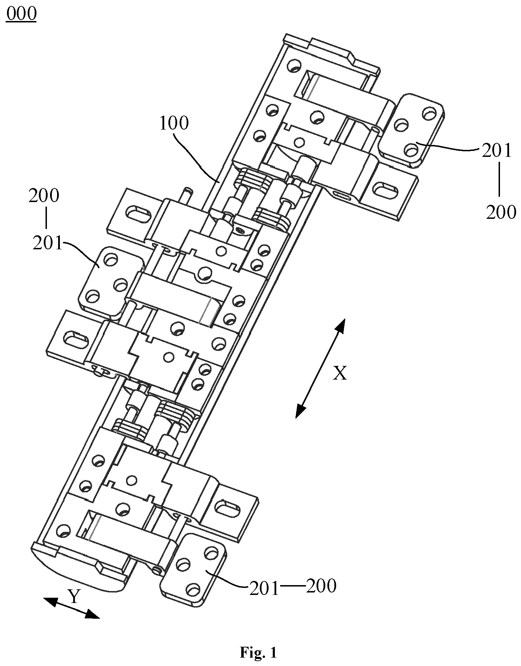

Referring to FIG. 1, which is a schematic view of a hinge 000 according to an embodiment of the present invention. The hinge 000 may include a supporting base 100 and at least two flip parts 200.

The supporting base 100 in the hinge 000 may extend in a first direction X. It should be note that the supporting base 100 may have a split structure or a one-piece structure. For ease of processing, assembling and the like, the supporting base 100 may have the split structure and be connected together by a connector, such as a support for supporting a screen. The supporting base 100 may also have the one-piece structure, and the supporting base 100 may have a bar-shaped structure extending in the first direction. It should be noted that the above description of the supporting base 100 is merely illustrative and not limiting, and the embodiments of the present invention do not particularly limit a shape, a connection form and the like of the supporting base 100.

The at least two flip parts 200 in the hinge 000 may be rotatably connected to the supporting base 100. It may be understood that the at least two flip parts 200 are each connected to the supporting base 100 and that the at least two flip parts 200 are rotatable relative to the supporting base 100. Here, the at least two flip parts 200 may be distributed on both sides of the supporting base 100 in a second direction Y in case that the hinge 000 is in an unfolded state. It should be noted that a side of the supporting base 100 in the hinge 000 facing the flexible display panel in the foldable display device is flush with a side of the flip part 200 facing the flexible display panel in case that this hinge 000 is assembled into the foldable display device and the hinge 000 is in the unfolded state, so that the hinge 000 can better support a foldable display portion in the flexible display panel. In the present invention, "flexible display panel" may refer to a display screen made of materials that allow it to bend or fold without breaking or distorting the displayed images. This flexibility may be essential for the operation of the foldable display device, as it enables the screen to conform to the movements of the hinge and housing components.

It should be noted that the at least two flip parts 200 in the hinge 000 include at least a first flip part and a second flip part, and the first flip part and the second flip part are arranged side by side and are connected to opposite sides of the supporting base 100. In order to reduce a size of the supporting base 100 in the hinge 000 in the second direction Y, the first flip part and the second flip part are rotatably connected to the supporting base 100 at different positions of the supporting base 100, respectively. In a possible implementation, a part of the supporting base 100 rotatably connected with the first flip part and a part of the supporting base 100 rotatably connected with the second flip part do not overlap.

Further, in case that the supporting base 100 has the split structure, respective flip parts 200 may be rotatably connected to different parts of the supporting base 100, and the different parts of the supporting base 100 may be connected together by the connector. In case that the supporting base 100 has the one-piece structure, respective flip parts 200 are connected to parts at different positions of the supporting base 100.

The first direction X intersects with the second direction Y, i.e., the first direction X and the second direction Y form a preset included angle. For example, the first direction X may be perpendicular to the second direction Y. As another example, as shown in FIG. 1, the first direction X may be a length direction of the supporting base 100 and the second direction Y may be the width direction of the supporting base 100. In the present invention, in case that the hinge 000 is in a folded state, the at least two flip parts 200 may be distributed on the same side of the supporting base 100 in a direction perpendicular to the first direction X and perpendicular to the second direction Y, and the two flip parts 200 may be arranged to face each other in the second direction Y.

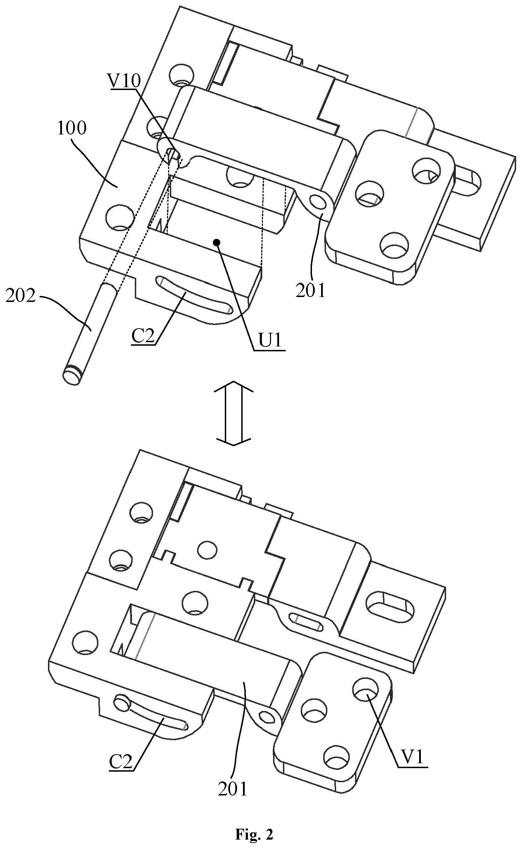

In order to more clearly see a connection relationship between the flip part 200 and the supporting base 100, reference is made to FIG. 2, which is an exploded view of a flip part according to an embodiment of the present invention. The flip part 200 may include: a first rotating member 201, and a first connecting portion 202 connected to a first end of the first rotating member 201. In the present invention, the supporting base 100 may have a first arc-shaped sliding groove C1, and a part of the first connecting portion 202 may be located in the first arc-shaped sliding groove C1. Here, the part of the first connecting portion 202 located in the first arc-shaped sliding groove C1 may slide in the first arc-shaped sliding groove C1.

Here, the first connecting portion 202 may be directly connected to the first rotating member 201 or may be indirectly connected to the first rotating member 201 through other parts. The first rotating member 201 and the first connecting portion 202 may be split structures (that is, they are separate) in case that the first connecting portion 202 is directly connected to the first rotating member 201. For example, the first rotating member 201 may have a mounting hole, and a part of the first connecting portion 202 may be inserted into the mounting hole of the first rotating member 201. In addition, the first rotating member 201 and the first connecting portion 202 may be a one-piece structure (that is, they are integral). For example, the first rotating member 201 and the first connecting portion 202 may be welded together by welding. It should be noted that the following embodiments are described by taking an example in which the first rotating member 201 has the mounting hole, and the first connecting portion 202 is inserted into the mounting hole.

For example, the first end of the first rotating member 201 has a first mounting hole V10, and the first connecting portion 202 may be inserted into the first mounting hole V10 and connected to the first end of the first rotating member 201. Here, a part of the first connecting portion 202 is located inside the first mounting hole V10, and another part of the first connecting portion 202 is located outside the first mounting hole V10. Further, the part of the first connecting portion 202 located outside the first mounting hole V10 may be located inside the first arc-shaped sliding groove C1.

It should be noted that, in FIG. 2, the first connecting portion 202 is illustrated as an example having a shaft-shaped structure. In other possible implementations, the first connecting portion 202 may also have a block-shaped structure or a plate-shaped structure arranged on the first rotating member 201. Here, in case that the first connecting portion 202 has the plate-shaped structure, the plate-shaped structure may be an arc-shaped slide plate matched with the shape of the first arc-shaped sliding groove C1. The structure of the first connecting portion 202 is not particularly limited in the embodiments of the present invention.

It should be noted that a second end of the first rotating member 201 in each flip part 200 in the hinge 000 is configured to be fixedly connected to the housing in the foldable display device. For example, the second end of the first rotating member 201 has a connector (not labeled), the connector may have one or more first through holes V1, the housing in the foldable display device may have one or more threaded holes in one-to-one correspondence and communication with the one or more first through holes V1, and the second end of the first rotating member 201 may be fixedly connected to the housing by screwing a screw through the first through hole V1 and the corresponding threaded hole. In this way, in the process of folding or unfolding the foldable display device equipped with the hinge 000, the housing of the foldable display device may drive the first rotating member 201 to rotate, so that the first connecting portion 202 connected to the first end of the first rotating member 201 can slide in the first arc-shaped sliding groove C1, and further the first rotating member 201 can rotate relative to the supporting base 100.

Here, it is possible to allow a rotation axis of the first rotating member 201 to be located outside the supporting base and to allow the rotation axis to have a certain distance from the supporting base 100 in case that the first rotating member 201 rotates relative to the supporting base 100, by setting a radian of the first arc-shaped sliding groove C1. In this way, even if the flexible display panel in the foldable display device tends to move outwards relative to the supporting base 100 during the unfolding of the foldable display device, the housing may also be moved outwards relative to the supporting base by rotating the first rotating member 201 relative to the supporting base 100. In this way, it is ensured that the housing does not pull the flexible display panel during the unfolding of the foldable display device.

In embodiments of the present invention, since the first rotating member 201 is connected to the supporting base via the first connecting portion 202, and the part of the first connecting portion 202 may be located in the first arc-shaped sliding groove C1 of the supporting base 100, the first connecting portion 202 may be limited by the first arc-shaped sliding groove C1 during the rotation of the first rotating member 201 relative to the supporting base 100, so that the first rotating member 201 connected to the first connecting portion 202 will not fall off the supporting base 100, thus making the hinge 000 more reliable, and hence improving the reliability of the foldable display device including the hinge 000.

In conclusion, the hinge according to embodiments of the present invention includes the supporting base and the at least two flip parts. The flip parts include the first rotating member, and the first connecting portion connected to the first end of the first rotating member, and the part of the first connecting portion may be located in the first arc-shaped sliding groove. Since the first rotating member is connected to the supporting base via the first connecting portion, and the part of the first connecting portion may be located in the first arc-shaped sliding groove of the supporting base, the first connecting portion may be limited by the first arc-shaped sliding groove during the rotation of the first rotating member relative to the supporting base, so that the first rotating member connected to the first connecting portion will not fall off the supporting base, thus making the hinge more reliable, and hence improving the reliability of the foldable display device including the hinge.

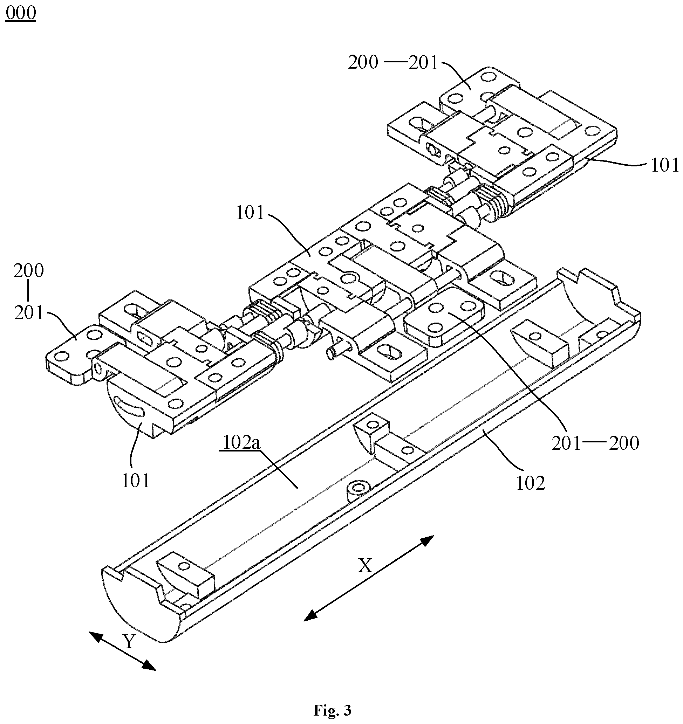

In embodiments of the present invention, as shown in FIG. 3, which is an exploded view of a hinge according to embodiments of the present invention, the at least two flip parts 200 in the hinge 000 may be arranged side by side in the first direction X. For example, respective first rotating members 201 in the at least two flip parts 200 in the hinge 000 may be sequentially arranged in the first direction X. Also, two flip parts 200 in the at least two flip parts 200 are distributed on both sides of the supporting base 100 in the second direction Y. For example, in a possible implementation, for two flip parts 200 distributed adjacently in the first direction X, one flip part 200 may be distributed on one side of the supporting base 100 in the second direction Y and the other flip part 200 may be distributed on the other side of the supporting base 100 in the second direction Y.

In embodiments of the present invention, since the respective first rotating members 201 in the at least two flip parts 200 in the hinge 000 are sequentially arranged in the first direction X, and two flip parts 200 in the at least two flip parts 200 are distributed on both sides of the supporting base 100 in the second direction Y, the two first rotating members 201 of the two flip parts 200 distributed on both sides of the supporting base 100 in the second direction Y are not symmetrically distributed relative to the supporting base 100, and the two first rotating members 201 of the two flip parts 200 may be centro-symmetrically distributed. To this end, in the second direction Y, the first rotating member 201 of each flip part 200 may be connected to the entire supporting base 100. In this way, it is possible to effectively increase a size of the first rotating member 201 in the flip part 200, so that a strength of the flip part 200 is high, thus effectively reducing a possibility of damage to the hinge 000 after the hinge 000 is struck, and further improving the reliability of the foldable display device equipped with the hinge 000.

Furthermore, in case that the at least two flip parts 200 in the hinge 000 are arranged side by side in the first direction X, it is also possible to ensure that the supporting base 100 has a small width in the second direction Y, so that the foldable display device in the folded state has a thin thickness after the foldable display device incorporating such hinge 000 is folded.

In some embodiments, the supporting base 100 in the hinge 000 may include a base body 101 and a protective shell 102. The protective shell 102 may be snap-fitted to the base body 101, and the base body 101 may be rotatably connected to the flip part 200.

In a possible implementation, the base body 101 has a one-piece structure, and each flip part 200 in the hinge 000 may be rotatably connected to the same base body 101. In this case, the base body 101 in the supporting base 100 may be elongated, and the base body 101 may extend in the first direction X. Moreover, respective first rotating members 201 in respective flip parts 200 may be connected to the base body 101 in sequence at different positions of the base body 101 in the first direction X.

In another possible implementation, the base body 101 has the split structure, and each flip part 200 in the hinge 000 may be rotatably connected to the corresponding base body 101. In this case, at least two base bodies 101 are provided in the supporting base 100, and the at least two base bodies 101 may have a one-to-one correspondence with the at least two flip parts 200, and the first rotating member 201 in each flip part 200 may be rotatably connected to the corresponding base body 101. Here, the at least two base bodies 101 in the supporting base 100 may be arranged in the protective shell 102 in sequence in the first direction X.

For example, the protective shell 102 in the supporting base 100 may have an accommodating groove 102a, and each base body 101 in the supporting base 100 may be located in the accommodating groove 102a, so that each base body 101 can be assembled into the protective shell 102.

Here, since the respective base bodies 102 in the supporting base 100 are sequentially distributed in the protective shell 101 in the first direction X, the respective flip parts 200 corresponding to the respective base bodies 102 are also sequentially distributed in the first direction X. In this way, there is no need to divide the base body into two symmetrical parts and to connect the two symmetrical parts to two symmetrically arranged flip parts respectively. Each flip part 200 in this hinge 000 may be rotatably connected to the corresponding whole base body 102, so that the flip part 200 has a large size and the supporting base 100 has a small width in the second direction Y.

It should be noted that the protective shell 102 may not only protect each base body 101, but also encapsulate each base body 101, so that different flip parts 200 may be connected into a whole.

In embodiments of the present invention, as shown in FIG. 2, the supporting base 100 may also have a first hollowed-out groove U1, and the first arc-shaped sliding groove C1 may be in communication with the first hollowed-out groove U1. The first end of the first rotating member 201 in the flip part 200 may be located in the first hollowed-out groove U1, and may be rotatably connected to the supporting base 100 through the first connecting portion 202 in the first hollowed-out groove U1.

For example, both the first hollowed-out groove U1 and the first arc-shaped sliding groove C1 may be arranged in the base body 101 of the supporting base 100. In this way, the first end of the first rotating member 201 may be rotatably connected to the base body 101 in the first hollowed-out groove U1. In this case, the first end of the first rotating member 201 may rotate relative to the base body 101 in the first hollowed-out groove U1, so that a side of the base body 101 facing away from the protective shell 102 may be flush with a side of the first rotating member 201 facing away from the protective shell 102 in case that the hinge 000 is in the unfolded state, thus better supporting a foldable display part in the flexible display panel.

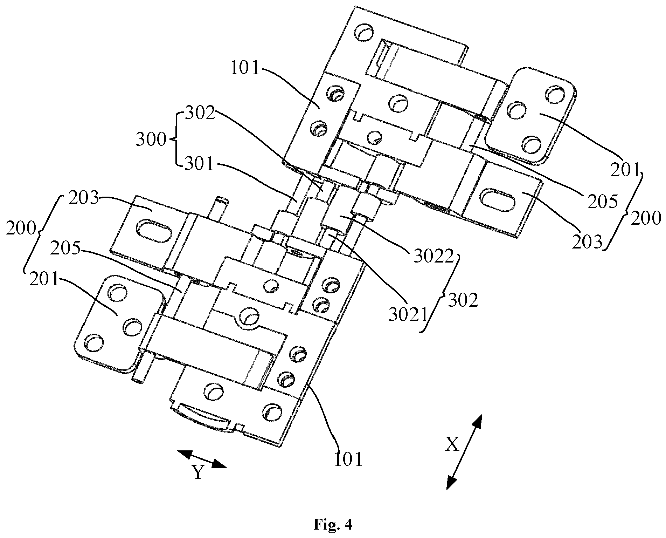

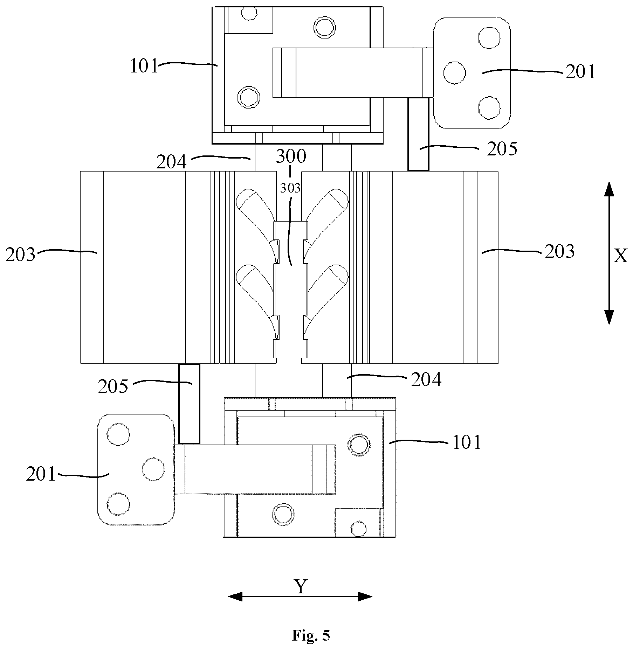

In embodiments of the present invention, in order to clearly see the structure of the flip part, reference may be made to FIG. 4 and FIG. 5. FIG. 4 is a partial schematic view of a hinge according to an embodiment of the present invention, and FIG. 5 is another partial schematic view of a hinge according to an embodiment of the present invention. The flip part 200 in the hinge 000 may include a rotating assembly 203. Here, a first end of the rotating assembly 203 may rotatably connected to the supporting base 100. For example, the first end of the rotating assembly 203 may be rotatably connected to the base body 101 in the supporting base 100. In the flip part 200, a second end of the rotating assembly 203 may be slidably connected to the second end of the first rotating member 201. In this way, in one flip part 200, the first rotating member 201 may drive the rotating assembly 203 to rotate relative to the base body 101 in case that the first rotating member 201 rotates relative to the base body 101.

In some embodiments, as shown in FIGS. 4 and 5, the hinge 000 may further include a synchronizing mechanism 300. Here, the synchronizing mechanism 300 may be respectively connected to the two flip parts 200 located on opposite sides of the supporting base 100. For example, the embodiments of the present invention are all described by taking an example in which the synchronizing mechanism 300 is respectively connected to two rotating assemblies 203 of the two flip parts 200 located on opposite sides of the supporting base 100. In other possible implementations, the synchronizing mechanism 300 may also be respectively connected to two first rotating members 201 of the two flip parts 200 located on opposite sides of the supporting base 100. The embodiments of the present invention do not limit this.

In this case, for the two flip parts 200 distributed on both sides of the supporting base 100 in the second direction Y, the rotating assembly 203 in one flip part 200 may be connected to the rotating assembly 203 in the other flip part 200 through the synchronizing mechanism 300. In this way, during the folding and unfolding of the foldable display device equipped with the hinge 000, in case that the housing in the foldable display device drives the first rotating member 201 in one flip part 200 to rotate, the first rotating member 201 in the other flip part 200 may also rotate synchronously through the mutual fit of the two rotating assemblies 203 in the two flip parts 200 and the synchronizing mechanism 300 connected to the two rotating assemblies 203, so that the stability of the hinge 000 during the folding and unfolding can be effectively improved.

In embodiments of the present invention, as shown in FIGS. 4 and 5, the rotating assembly 203 in the flip part 200 has various structures, and the synchronizing mechanisms 300 with different structures may also be adopted to connect the rotating assemblies 203 with different structures to each other. The embodiments of the present invention will be illustrated by taking the following two optional implementations as examples.

In a first optional implementation, as shown in FIG. 4, the synchronizing mechanism 300 in the hinge 000 may include two first synchronizing members 301. The two first synchronizing members 301 may be respectively connected to two rotating assemblies 203 in the two flip parts 200 located on opposite sides of the supporting base 100, and the two rotating assemblies 203 are connected to each other. In this way, in case that one flip part 200 rotates relative to the supporting base 100, the rotating assembly 203 in the other flip part 200 is driven to rotate by the rotating assembly 203 in the one flip part 200 and the two first synchronizing members 301, so that the other flip part can also rotate relative to the supporting base 100. Moreover, the two flip parts 200 have opposite rotation directions. For example, in case that one flip part 200 rotates clockwise relative to the supporting base 100, the other flip part 200 rotates counterclockwise relative to the supporting base 100 through the driving of the synchronizing mechanism 300, so that the two flip parts 200 can move towards each other or away from each other, and hence the hinge 000 can be folded or unfolded.

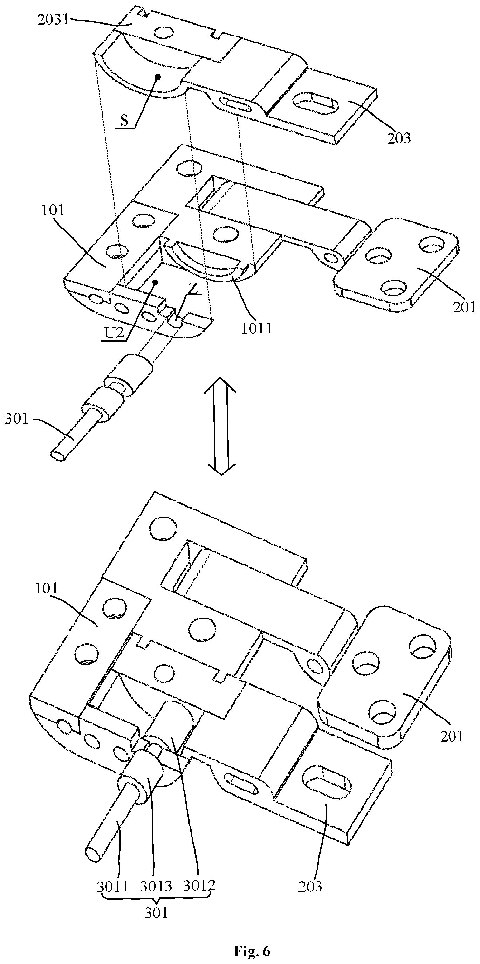

In some embodiments, referring to FIG. 4 and FIG. 6, FIG. 6 is a schematic view illustrating fit between a rotating assembly and a base body according to an embodiment of the present invention. The first end of the rotating assembly 203 in the flip part 200 may have a second rotating member 2031. The supporting base 100 may also have a second hollowed-out groove U2 and a sliding portion 1011 located in the second hollowed-out groove U2. For example, both the second hollowed-out groove U2 and the sliding portion 1011 may be located in the base body 101 in the supporting base 100.

The second rotating member 2031 may be located in the second hollowed-out groove U2 and rotatably connected to the sliding portion 1011. In this way, the rotating assembly 203 in the flip part 200 may rotate relative to the corresponding base body 101 through the mutual fit between the second rotating member 2031 and the sliding portion 1011. In this case, the first end of the first rotating member 201 may rotate relative to the base body 101 in the first hollowed-out groove U1, and the rotating assembly 203 may rotate relative to the base body 101 in the second hollowed-out groove U2 through the second rotating member 2031, so that the side of the base body 101 facing away from the protective shell 102 may be flush with the side of the first rotating member 201 facing away from the protective shell 102, and may also be flush with a side of the rotating assembly 203 facing away from the protective shell 102 in case that the hinge 000 is in the unfolded state, so that the foldable display part in the flexible display panel can be better supported.

In some embodiments, the first synchronizing member 301 in the synchronizing mechanism 300 may include a first shaft 3011 and a roller 3012 fitted over the first shaft 3011 and fixedly connected to the first shaft 3011. The first shaft 3011 is configured to mount the first synchronizing member 301 to the base body 101, so that the two flip parts located on opposite sides of the supporting base 100 can rotate synchronously. Here, the first shaft 3011 in the first synchronizing member 301 may be rotatably connected to the base body 101, and the roller 3012 in the first synchronizing member 301 may be connected to the second rotating member 2031. In this way, the second rotating member 2031 may rotate relative to the sliding portion 1011 in case that the rotating assembly 203 rotates relative to the base body 101. Through the connection between the second rotating member 2031 and the roller 3012, the second rotating member 2031 may drive the roller 3012 to rotate, so that the roller 3012 may drive the first shaft 3011 to rotate relative to the base body 101. In this way, the rotating assembly 203 may also drive the first synchronizing member 301 to rotate relative to the base body 101 in case that the rotating assembly 203 rotates relative to the base body 101.

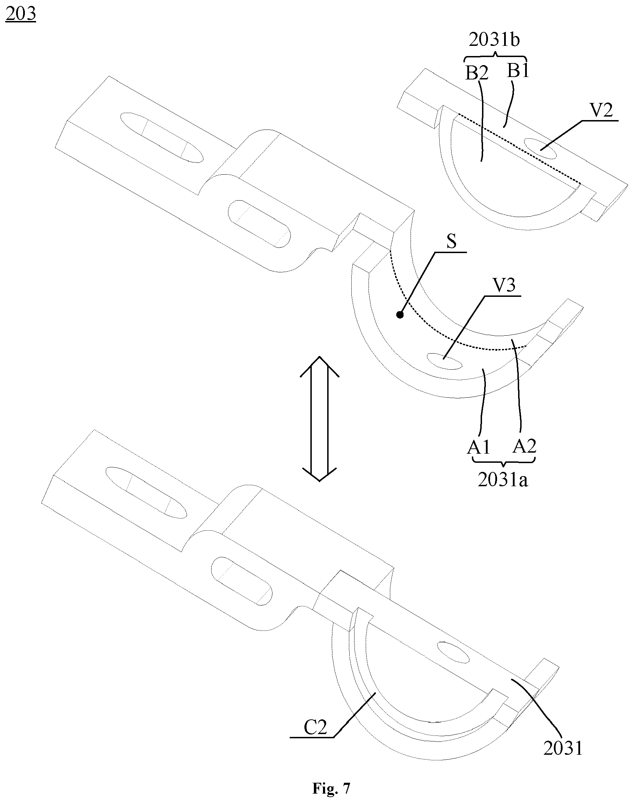

In some embodiments, as shown in FIG. 7, which is a schematic view of a second synchronizing member according to an embodiment of the present invention, the second rotating member 2031 arranged at the first end of the rotating assembly 203 may include a second connecting portion 2031a and a third connecting portion 2031b. Here, the second connecting portion 203 1a may be fixedly connected to the first end of the rotating assembly 203. Moreover, the second connecting portion 2031a may be connected to the third connecting portion 2031b in an assembled manner.

For example, the third connecting portion 2031b may have a second through hole V2, and the second connecting portion 2031a may have a threaded hole V3 in communication with the second through hole V2, and the third connecting portion 2031b may be fixed to a side of the second connecting portion 2031a by screwing a screw through the second through hole V2 and the threaded hole V3.

After the third connecting portion 2031b is fixedly connected to the side of the second connecting portion 2031a, a surface of the second connecting portion 2031a and a surface of the third connecting portion 2031b may enclose a second arc-shaped sliding groove C2, and at least part of the sliding portion 1011 in the base body 101 may be located in the second arc-shaped sliding groove C2. In this way, the second rotating member 2031 can rotate relative to the sliding portion 1011 in case that the sliding portion 1011 slides in the second arc-shaped sliding groove C2 relative to the second arc-shaped sliding groove C2, so that the rotating assembly 203 may rotate relative to the base body 101.

It should be noted that the sliding portion 1011 in the base body 101 may be a protrusion, a plate-shaped structure or a block-shaped structure matched in shape with the second arc-shaped sliding groove C2. Taking an example in which the sliding portion 1011 is the protrusion, an extension direction of the protrusion is the same with an extension direction of the second arc-shaped sliding groove C2, and the present invention does not specifically limit the specific shape of the sliding portion 1011.

In embodiments of the present invention, the second connecting portion 2031a in the second rotating member 2031 may include a first section A1 fixedly connected with the third connecting portion 2031b and a second section A2. Here, the first section A1 and the second section A2 may be arranged side by side. For example, the first section A1 and the second section A2 may be arranged side by side in the first direction X, and may be fixedly connected into a whole.

The first section A1 in the second connecting portion 2031a may be connected to the third connecting portion 2031b. For example, the first section A1 in the second connecting portion 2031a and the third connecting portion 2031b may be connected by the screw. Moreover, a surface of the first section A1 in the second connecting portion 2031a and the surface of the third connecting portion 2031b may enclose the second arc-shaped sliding groove C2.

The second section A2 in the second connecting portion 2031a may be staggered from the third connecting portion 2031b. That is, the third connecting portion 2031b is not connected to the second section A2 in the second connecting portion 2031a. That is, the third connecting portion 2031b is distributed on the first section A1, but not on the second section A2. In this way, the roller 3012 in the first synchronizing member 301 may be connected to the second section A2. The first section A1 and the second section A2 in the second connecting portion 2031a may slide relative to the sliding portion 1011 along the second arc-shaped sliding groove C2 to drive the roller 3012 to rotate. In this way, the rotating assembly 203 may drive the roller 3012 to rotate through the second section A2 of the second rotating member 2031 in case that the rotating assembly 203 rotates relative to the base body 101, so that the roller 3012 may drive the first shaft 3011 to rotate synchronously.

In this way, the roller 3012 and the third connecting portion 2031b may be fitted with the second connecting portion 2031a at the same time, so that the second rotating member 2031 may be rotatably connected to the sliding portion 1011 and also connected to the roller 3012 to drive the roller to rotate.

In the present invention, a surface of the second connecting portion 2031a in the second rotating member 2031 facing the roller 3012 may be an arc-shaped surface S. Here, the surface of the second connecting portion 2031a facing the roller 3012 is a surface of the second connecting portion 2031a facing away from the protective shell 102 in the supporting base 100. In this way, a surface of the first section A 1 in the second connecting portion 2031a facing away from the protective shell 102 and a surface of the second section A2 in the second connecting portion 2031a facing away from the protective shell 102 are both arc-shaped surfaces.

In a possible implementation, the arc-shaped surface of the second section A2 in the second connecting portion 2031a may be frictionally connected to the roller 3012. In this way, the arc-shaped surface S of the second connecting portion 2031a in the rotating assembly 203 may also rotate relative to the base body 101 in case that the rotating assembly 203 rotates relative to the base body 101. The roller 3012 may also rotate by the friction between the arc-shaped surface S of the second section A2 and the roller 3012.

In another possible implementation, the arc-shaped surface of the second section A2 in the second connecting portion 2031a is provided with a meshing piece, so that the second section A2 may be connected to the roller 3012 through the meshing piece. In this way, in case that the rotating assembly 203 rotates relative to the base body 101, the arc-shaped surface S of the second connecting portion 2031a in the rotating assembly 203 may also rotate relative to the base body 101. The roller 3012 may also rotate by the meshed connection between the meshing piece on the second section A2 and the roller 3012.

For example, the arc-shaped surface S of the second connecting portion 2031a facing the roller 3012 may be an arc-shaped concave surface. In the second section A2, the meshing piece may include one or more internal teeth (not labeled in the drawings) located on the arc-shaped surface S. The roller 3012 in the first synchronizing member 301 may have one or more external teeth (not labeled in the drawings), and these external teeth may be meshed with the internal teeth. Here, in case that the second section A2 has the one or more internal teeth located on the arc-shaped surface S, the structure of the second section A2 is similar to a gear ring structure. In case that the roller 3012 has the one or more external teeth, the roller 3012 is similar to an external gear, and the external gear may be meshed with the gear ring structure. In this way, the second section A2 may drive the roller 3012 to rotate in case that the second section A2 rotates, so that the first synchronizing member 301 may rotate.

In embodiments of the present invention, the arc-shaped surface S of the second connecting portion 2031a facing the roller 3012 may be the arc-shaped concave surface. The third connecting portion 2031b may include a body section B1 and a protruding section B2. The body portion B1 has a first arc-shaped convex surface (not labeled in FIG. 7), and the protruding section B2 has a second arc-shaped convex surface (not labeled in FIG. 7) coaxial with the first arc-shaped convex surface. That is, the first arc-shaped convex surface of the body section B1 and the second arc-shaped convex surface of the protruding section B2 are distributed in parallel. In the present invention, the body section B1 in the third connecting portion 2031b may be bridged on the second connecting portion 203 1a, and the first arc-shaped convex surface of the body section B1 may abut against the arc-shaped concave surface S of the first section A1 in the second connecting portion 2031a. In this way, the arc-shaped concave surface S of the first section A1 and the second arc-shaped convex surface of the protruding section B2 may enclose the second arc-shaped sliding groove C2.

Moreover, an assembling process of the rotating assembly 203 and the base body 101 can be simplified in case that the second rotating member 2031 is configured to include the second connecting portion 2031a and the third connecting portion 2031b. For example, in the assembling process of the rotating assembly 203 and the base body 100, the second connecting portion 2031a arranged at the first end of the rotating assembly 203 may be first placed in the second hollowed-out groove U2 of the base body 101, and the second connecting portion 2031a may be located on a side of the sliding portion 1011 adjacent to the protective shell 102. Then, the third connecting portion 2031b may be fixed on the first section A1 in the second connecting portion 2031a, and the third connecting portion 2031b may be located on a side of the sliding portion 1011 facing away from the protective shell 102. In this way, the rotating assembly 203 may be assembled to the base body 101.

In embodiments of the present invention, the first shaft 3011 in the first synchronizing member 301 may be rotatably connected to two base bodies 101 distributed adjacent to each other in the first direction X at the same time, and a part of the first shaft 3011 may be distributed between the two base bodies 101. The two flip parts 200 corresponding to the two base bodies 101 may be two flip parts 200 distributed on both sides of the supporting base 100 in the second direction Y.

For example, as shown in FIG. 6, one of the two base bodies 101 may have a first supporting hole Z in communication with the second hollowed-out groove U2, a first end of the first shaft 3011 may pass through the first supporting hole Z and then extend into the second hollowed-out groove U2, and the roller 3012 may be fitted over the first shaft 3011 in the second hollowed-out groove U2. In this case, the second section A2 of the second rotating member 2031 may rotate relative to the base body 101 in case that the second rotating member 2031 rotates relative to the sliding portion 1011. Since the first shaft 3011 may be rotatably connected to the base body 101 in the first supporting hole Z, under the limiting of the first supporting hole Z, the second section A2 may only drive the roller 3012 to spin, so that the first synchronizing member 301 may only spin to ensure that the first synchronizing member 301 will not move following the track of the first rotating member 201.

As shown in FIG. 4, the other one of the two base bodies 101 has a second supporting hole (not labeled in the drawings). The first end of the first shaft 3011 may pass through the first supporting hole Z, a second end of the first shaft 3011 may be located in the second supporting hole, and the first shaft 3011 may be rotatably connected to the two base bodies 101. In this way, the first shaft 3011 can spin stably by the two base bodies 101.

In some embodiments, as shown in FIGS. 4 and 6, the first synchronizing member 301 may further include a first synchronizing wheel 3013 fitted over and fixedly connected to the first shaft 3011. The first synchronizing wheel 3013 may be a pulley or a gear. The first synchronizing wheel 3013 in the first synchronizing member 301 may be located outside the base body 101, and the first synchronizing wheel 3013 may abut against the base body 101. For example, an end face of the first synchronizing wheel 3013 adjacent to the base body 101 may abut against the base body 101. In this way, there is a certain friction between the end face of the first synchronizing wheel 3013 adjacent to the base body 101 and the base body 101 in case that the first synchronizing member 301 rotates. Through this friction, the hinge 000 may have a certain damping sense during the folding or the unfolding so as to ensure the great stability of the hinge 000 during the folding or the unfolding.

In the present invention, for the two flip parts 200 distributed on both sides of the supporting base 100 in the second direction Y, two first synchronizing wheels 3013 in two first synchronizing members 301 of the two flip parts 200 are synchronously connected to each other. In this way, in case that one of the two first synchronizing members 301 rotates, the other first synchronizing member 301 may also rotate through the mutual fit of the two first synchronizing wheels 3013, and this first synchronizing member 301 has an opposite rotation direction. For example, in case that one first synchronizing member 301 spins clockwise, the other first synchronizing member 301 may spin counterclockwise, so that the two flip parts 200 where the two first synchronizing members 301 are located may move towards each other or away from each other, and thus the hinge 000 may be folded or unfolded.

For example, as shown in FIG. 4, the synchronizing mechanism 300 may further include two second synchronizing members 302 located between two first synchronizing members 301. In some embodiments of the present invention, more than two second synchronizing members 302 may be provided and arranged between the two first synchronizing members 301, and the more than two second synchronizing members 302 are connected with each other. Here, the second synchronizing member 302 includes a second shaft 3021 connected to the supporting base 100 and a second synchronizing wheel 3022 fitted over the second shaft 3021. The second shaft 3021 is configured to mount the second synchronizing member 302 to the base body 101, so that the two flip parts located on opposite sides of the supporting base 100 can rotate synchronously. In a possible case, the second shaft 3021 may be fixedly connected to the base body 101 in the supporting base 100, and the second synchronizing wheel 3022 may rotate on the second shaft 3021. In another possible case, the second shaft 3021 may be rotatably connected to the base body 101 in the supporting base 100, the second synchronizing wheel 3022 is fixedly connected to the second shaft 3021, and may rotate synchronously with the second shaft 3021.

The second synchronizing wheel 3022 may be a pulley or a gear. In case that the second synchronizing wheel 3022 is a gear, the second synchronizing wheel 3022 in the second synchronizing member 302 may be meshed with the first synchronizing wheel 3013 in the adjacent first synchronizing member 301, and two second synchronizing wheels 3022 in the two second synchronizing members 302 located between the two first synchronizing members 301 are meshed with each other.

In this situation, in case that one first synchronizing member 301 rotates, the first synchronizing wheel 3013 in this first synchronizing member 301 may drive the second synchronizing wheel 3022 of the second synchronizing member 302 adjacent thereto to rotate, so that this second synchronizing wheel 3022 may drive the second synchronizing wheel 3022 of the other second synchronizing member 302 to rotate, and the second synchronizing wheel 3022 of the other second synchronizing member 302 may drive the first synchronizing wheel 3013 of the other first synchronizing member 301 to rotate, so as to ensure that the other first synchronizing member 301 may also rotate.

In this way, for the two flip parts 200 distributed on both sides of the supporting base 100 in the second direction Y in the hinge 000, in case that one flip part 200 rotates relative to the base body 101, the first rotating member 201 in the flip part 200 may drive the first synchronizing member 301 to rotate through the rotating assembly 203, and this first synchronizing member 301 may drive the first synchronizing member 301 in the other flip part 200 to rotate through the two second synchronizing members 302, so that the first synchronizing member 301 in the other flip part 200 may drive the first rotating member 201 to rotate through the rotating assembly 203, thus enabling the two flip parts 200 to rotate synchronously. Here, a spinning direction of the first synchronizing member 301 in one flip part 200 is opposite to a spinning direction of the first synchronizing member 301 in the other flip part 200. In this way, the rotation directions of the two flip parts 200 during the synchronous rotation are also opposite so as to ensure that the hinge 000 may be folded or unfolded.

Here, for the two flip parts 200 distributed on both sides of the supporting base 100 in the second direction Y in the hinge 000, parts of the two first synchronizing members 301 in the synchronizing mechanism 300 may be distributed between the two base bodies 101 corresponding to the two flip parts 200, the two second synchronizing members 302 in the synchronizing mechanism 300 between the two first synchronizing members 301 may also be distributed between the two base bodies 101, and both ends of each second synchronizing member 302 may be connected to the two base bodies 101. In this case, two second synchronizing wheels 3022 and two first synchronizing wheels 3013 may be distributed between the two base bodies 101 in the first direction X, and the two second synchronizing wheels 3022 and the two first synchronizing wheels 3013 may be meshed in sequence.

In a second alternative implementation, as shown in FIG. 5, the synchronizing mechanism 300 in the hinge 000 may include a fixing member 303. Here, the fixing member 303 may be located in the protective shell 102 in the supporting base 100, and the fixing member 303 may be distributed between two adjacent base bodies 101. The two flip parts 200 corresponding to the two adjacent base bodies 101 may be two flip parts 200 distributed on both sides of the supporting base 100 in the second direction Y. Moreover, the fixing member 303 may be distributed between the two rotating assemblies 203 in the two flip parts 200. That is, the fixing member 303 may be distributed between the two base bodies 101 in the first direction X, and also between the two rotating assemblies 203 in the second direction Y.

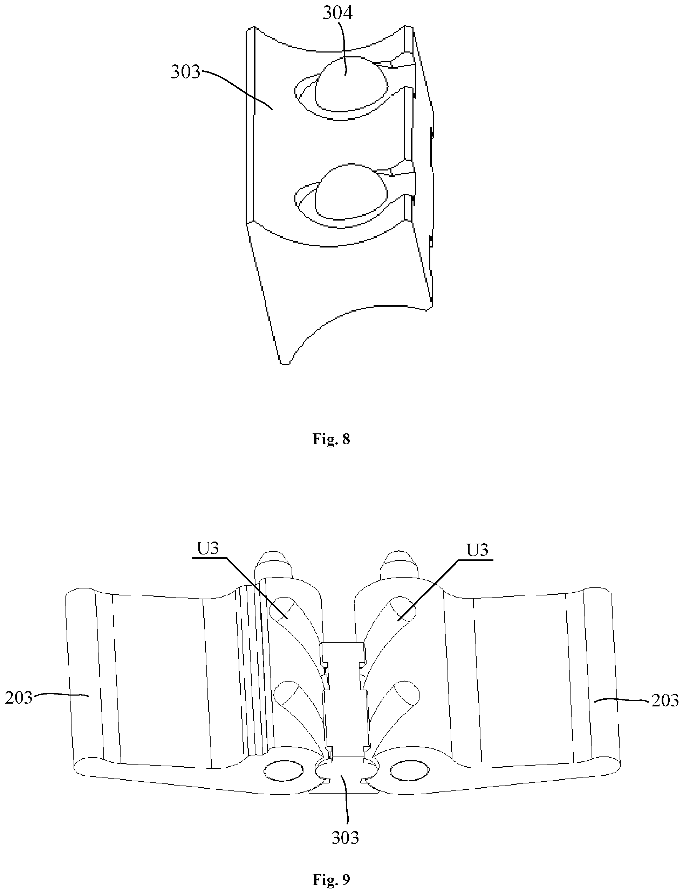

In order to see a structure of the fixing member 303 more clearly, reference is made to FIG. 8, which is a schematic view of a fixing member according to an embodiment of the present invention. The fixing member 303 may have a rolling part 304, and the rolling part 304 may be a ball or a roller, which is not limited in embodiments of the present invention. For example, two opposite sides of the fixing member 303 in the second direction Y may each have a limiting groove, part of the rolling part 304 may be located in the limiting groove, and the limiting groove may limit the rolling part 304, so that the rolling part 304 will not fall out of the limiting groove. Moreover, the rolling part 304 may also freely roll in the limiting groove. Here, each side of the fixing member 303 may be provided with one or more rolling parts 304. It should be noted that FIG. 8 schematically illustrates an example in which two rolling parts 304 are arranged on each side of the fixing member 303.

In order to clearly see the connection relationship between the fixing member 303 and the rotating assembly 203, reference is made to FIG. 9, which is a schematic view of connection between a fixing member and a rotating assembly according to an embodiment of the present invention. A side of the rotating assembly 203 in the flip part 200 adjacent to the fixing member 303 has a guide groove U3, and the guide groove U3 may be fitted with the rolling part 304 arranged on a side of the fixing member 303 adjacent to this rotating assembly 203. Part of the rolling part 304 may be located in the guide groove U3, and the rolling part 304 may slide in the guide groove U3. It should be noted that the rolling part 304 can freely roll in the limiting groove of the fixing member 303. Therefore, the rolling part 304 may slide in the guide groove U3 more easily.

Here, the number of the guide grooves U3 arranged on the side of the rotating assembly 203 may be the same with the number of the rolling parts 304 arranged on the side of the fixing member 303 adjacent to this rotating assembly 203, and part of each rolling part 304 may be located in the corresponding guide groove U3 and can slide in the corresponding guide groove U3.

In some embodiments, an extension direction of the guide groove U3 arranged on the side of the rotating assembly 203 adjacent to the fixing member 303 may be curve-shaped. That is, the guide groove U3 is a curve-shaped sliding groove and has a curve-shaped guiding direction. A "curve-shaped guiding direction" may refer to the path or trajectory along which components move or are guided. This path may not be linear but follows a curved geometry, which can be circular, elliptical, or any other nonlinear shape. The curve shape may be integral to the operation of the hinge mechanism by guiding the movement of the rolling part in a specific, predetermined manner.

In this case, for the two flip parts 200 distributed on both sides of the supporting base 100 in the second direction Y in the hinge 000, in case that one flip part 200 rotates relative to the base body 101, the first rotating member 201 in this flip part 200 may drive the rotating assembly 203 to rotate, so that the rolling part 304 on the side of the fixing member 303 facing this rotation assembly 203 can slide in the guide groove U3 of this rotation assembly 203. Since the extension direction of the guide groove U3 is curve-shaped, this rotating assembly 203 may drive the fixing member 303 to move in the protective shell 102 in a direction perpendicular to the first direction X and perpendicular to the second direction Y. In this way, the rolling part 304 on the other side of the fixing member 303 can slide in the guide groove U3 of the other rotating assembly 203 during movement of the fixing member 303, and this guide groove U3 is also curve-shaped. Thus, the fixing member 303 may drive the other rotating assembly 203 to rotate, so that the other rotating assembly 203 may drive the first rotating member 201 in the other flip part 200 to rotate.

It should be noted that, for the two flip parts 200 distributed on both sides of the supporting base 100 in the second direction Y in the hinge 000, the guide grooves U3 arranged on the sides of the two rotating assemblies 203 of the two flip parts 200 adjacent to the fixing member 303 are both curve-shaped, and the curve-shaped extension directions of the guide grooves U3 of the two rotating assemblies 203 are opposite. For example, the curve-shaped extension of the guide groove U3 of one rotating assembly 203 extends in a clockwise spiral direction, and the curve-shaped extension of the guide groove U3 of the other rotating assembly 203 extends in a counterclockwise spiral direction. In this way, in case that one rotating assembly 203 rotates, the other rotating assembly 203 may be driven to rotate through the fixing member 303, and the rotating directions of the two rotating assemblies are opposite. For example, in case that one rotating assembly 203 rotates clockwise, the other rotating assembly 203 may be driven to rotate counterclockwise under the driving of the fixing member 303. Thus, the rotation directions of the two flip parts 200 are also opposite in case that the two flip parts rotate synchronously, so as to ensure that the hinge 000 can be folded or unfolded.

It should also be noted that the extension direction of the guide groove U3 is curve-shaped, and the fixing member 303 will only move in the direction perpendicular to the first direction X and perpendicular to the second direction Y while the rolling part 304 of the fixing member 303 slides in the guide groove U3. In this way, the rotating assembly 203 may slide in the first direction X while the rolling part 304 of the fixing member 303 slides in the guide groove U3.

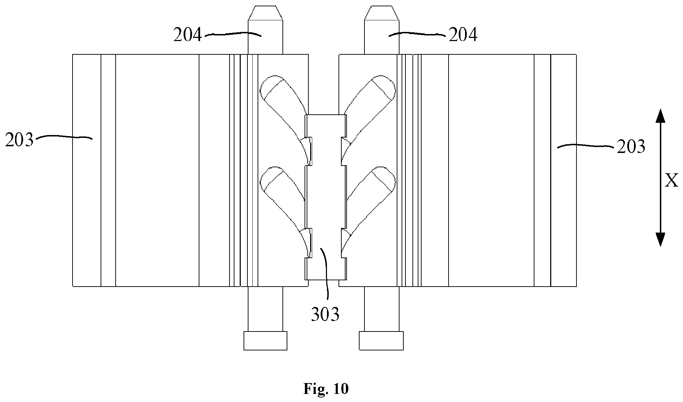

For example, as shown in FIG. 5 and FIG. 10, FIG. 10 is another schematic view of connection of a fixing member and a rotating assembly according to an embodiment of the present invention, the flip part 000 may further include a connecting shaft 204 connected to the supporting base 100, and the connecting shaft 204 may be connected to a side of the rotating assembly 203 adj acent to the fixing member 303.

The connecting shaft 204 may slide in the first direction X relative to the supporting base 100, and/or the rotating assembly 203 may slide in the first direction X relative to the connecting shaft 204.

Here, an axial direction of the connecting shaft 204 is parallel to the first direction X, and the connecting shaft 204 may be located between two adjacent base bodies 101 in the first direction X. The two flip parts 200 corresponding to the two base bodies 101 may be two flip parts 200 distributed on both sides of the supporting base 100 in the second direction Y.

In a possible implementation, both ends of the connecting shaft 204 may be fixedly connected to the two base bodies 101, respectively. In this case, the side of the rotating assembly 203 adjacent to the fixing member 303 may be movably connected to the connecting shaft 204, so that the rotating assembly 203 may not only allow the connecting shaft 204 to rotate, but also allow the rotating assembly 203 to slide in the axial direction of the connecting shaft 204.

In another possible implementation, both ends of the connecting shaft 204 may be movably connected to the two base bodies 101 respectively, and the side of the rotating assembly 203 adjacent to the fixing member 303 may be fixedly connected to the connecting shaft 204. In this case, the rotating assembly 203 and the connecting shaft 204 may not only rotate relative to the supporting base 100 at the same time, but also slide in the first direction X relative to the supporting base 100 at the same time.

In this way, during the rotation of the flip part 200 relative to the supporting base 100, the rotating assembly 203 may rotate relative to the fixing member 303, and in this process, the rotating assembly 203 can slide in the first direction X under a joint action of the rolling part 304 and the curve-shaped guide groove U3.

In some embodiments, in the above two optional implementations, in case that the flip part 200 rotates relative to the corresponding base body 101, a rotation axial direction of the first rotating member 201 of the flip part 200 is different from a rotation axial direction of the rotating assembly 203. In this way, during the rotation of the flip part 200, the first rotating member 201 will slide relative to the rotating assembly 203.

In this way, in the present invention, as shown in FIGS. 4 and 5, the flip part 200 may further include a fourth connecting portion 205 connected to the second end of the first rotating member 201. It should be noted that FIGS. 4 and 5 illustrate an example in which the fourth connecting portion 205 is a shaft-shaped structure. In other possible implementations, the fourth connecting portion 205 may also be a plate-shaped structure or a block-shaped structure arranged on the first rotating member 201. Embodiments of the present invention do not specifically limit the structure of the fourth connecting portion 205. In case that the fourth connecting portion 205 is the shaft-shape structure, an axial direction of the fourth connecting portion 205 may be parallel to the first direction X.

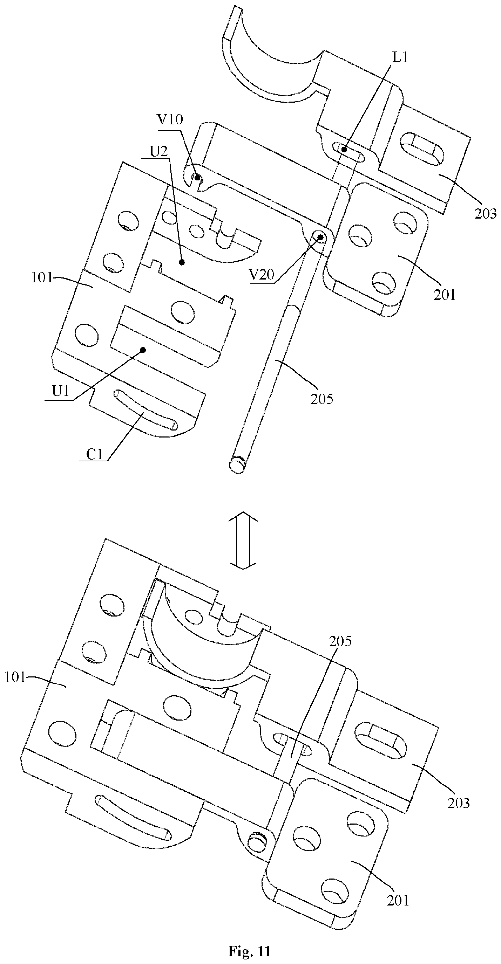

In order to clearly see the connection relationship between the fourth connecting portion 205 and the first rotating member 201, reference is made to FIG. 11, which is a schematic view of connection between a second end of a first rotating member and a second end of a rotating assembly according to an embodiment of the present invention. The second end of the first rotating member 201 in the flip part 200 may have a second mounting hole V20, and a part of the fourth connecting portion 205 may be connected to the second end of the first rotating member 201 in the second mounting hole V20. The second end of the rotating assembly 203 in the flip part 200 may have a sliding groove L1, the sliding groove L1 may be a linear sliding groove, and an extension direction of the sliding groove L1 may be parallel to the axial direction of the rotating assembly 203. An end of the fourth connecting portion 205 (which is connected to the second end of the first rotating member 201) facing away from the first rotating member 201 may be located in the sliding groove L1 and slidably connected to the rotating assembly 203. In this way, during the rotation of the first rotating member 201 relative to the base body 101, the first rotating member 201 may drive the rotating assembly 203 to rotate relative to the base body 101 through the fourth connecting portion 205, and the fourth connecting portion 205 connected to the second end of the first rotating member 201 can slide in the sliding groove L1, so that the first rotating member 201 may slide relative to the rotating assembly 203 in the extension direction of the sliding groove L1.

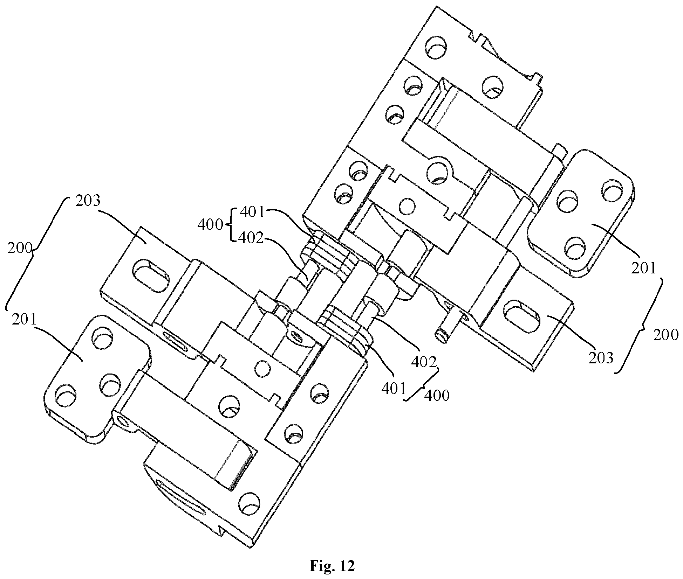

In the above two optional implementations, reference is made to FIG. 12, which is partial schematic view of another hinge according to an embodiment of the present invention, the hinge 000 may further include a torsion part 400 connected to the rotating assembly 203 of the flip part 200. The torsion part 200 may be configured to provide a damping force in case that the flip part 200 rotates relative to the base body 101. In this way, in case that a user needs to fold or unfold the foldable display device in which this hinge is mounted, a force to be applied to the housing in the foldable display device needs to be greater than the damping force, so that the flip part 200 in the hinge 000 can be rotated normally. However, after the foldable display device rotates to a certain angle, and the user stops applying the force to the housing, the damping force may be greater than a gravity of the foldable display device, so that the foldable display device can stay at this angle.

In embodiments of the present invention, the torsion part 400 in the hinge 000 may include one or more friction plates 401. The one or more friction plates 401 may be arranged side by side in the first direction X in at least one of following positions: between the first rotating member 201 and the supporting base 100 in any one of the flip parts 200; between the rotating assembly 203 and the supporting base 100 in any one of the flip parts 200; and between two adjacent flip parts 200.

In a possible implementation, at least one friction plate 401 may be distributed between the first rotating member 201 and the supporting base 100 in the flip part 200, and/or at least one friction plate 401 may be distributed between the rotating assembly 203 and the supporting base 100 in the flip part 200, and/or at least one friction plate 401 may be distributed between two flip parts 200 which are distributed adjacent to each other in the first direction X. It should be noted that Fig. 12 illustrates an example in which the one or more friction plates 401 in the torsion part 400 are arranged side by side between two adjacent flip parts 200 in the first direction X. Embodiments of the present invention do not specifically limit the position where the one or more friction plates 401 are arranged side by side.

In the present invention, the torsion part 400 may further include a transmission shaft 402 connected to the flip part 200. The one or more friction plates 401 in the torsion part 400 may be fitted over the transmission shaft 402 in the first direction.

It should be noted that in case that the rotating assembly 203 in the flip part 200 is the rotating assembly shown in the above first optional implementation, the structure of the transmission shaft 402 connected to the rotating assembly 203 in the torsion part 400 is the same with the structure of the first synchronizing member 301 in the above embodiments. Here, in case that the hinge 000 includes both the synchronizing mechanism 300 and the torsion part 400, the transmission shaft 402 and the first synchronizing member 301 are the same structure.

In case that the rotating assembly 203 in the flip part 200 is the rotating assembly shown in the second optional implementation, the structure of the transmission shaft 402 connected to the rotating assembly 203 in the torsion part 400 is the same with the structure of the connecting shaft 204 in the above embodiments. Here, in case that the hinge 000 includes both the synchronizing mechanism 300 and the torsion part 400, the transmission shaft 402 and the connecting shaft 204 are the same structure, and in this case, the connecting shaft 204 needs to be fixedly connected to the rotating assembly 203.

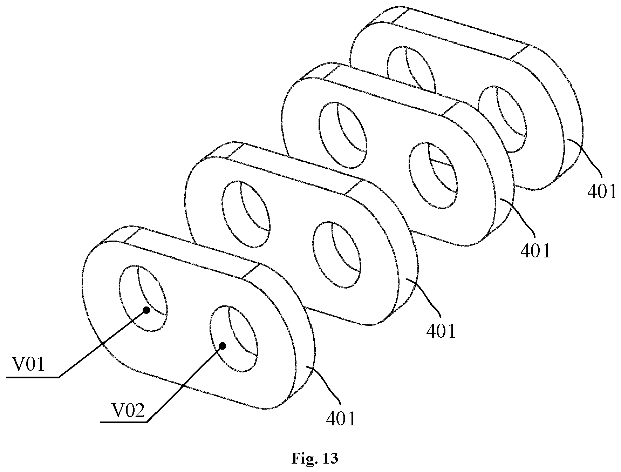

In order to clearly see the structure of the friction plate 401 in the torsion part 400, reference is made to FIG. 13, which is a schematic view of each friction plate according to an embodiment of the present invention, each friction plate 401 in the torsion part 400 has a through hole V01, and the through holes V01 in respective friction plates 401 are sequentially communicated, and the transmission shaft 402 may be in each through hole V01 and have an interference fit with each through hole V01.

For example, taking an example in which the transmission shaft 402 and the first synchronizing member 301 in the above embodiments are the same structure, the end of the first shaft 3011 in the first synchronizing member 301 facing away from the roller 3012 may extend into the through holes V01 of the respective friction plates 401, and may be in the interference fit with the through holes V01. In this way, during the rotation of the flip part 200, the friction plate 401 may exert a force on the first synchronizing member 301 through the through hole V01, so that the first synchronizing member 301 is subject to a resistance when rotating, thus ensuring that the torsion part 400 can provide the damping force in case that the flip part 200 rotates relative to the base body 101.

In embodiments of the present invention, each friction plate 401 may also have an auxiliary through hole V02 adjacent to the through hole V01, and an end of the second shaft 3021 in the second synchronizing member 302 may be inserted into the auxiliary through hole V02 of each friction plate 401, and may be in interference fit with the auxiliary through hole V02. In this way, during the rotation of the flip part 200, the friction plate 401 may exert a force on the second synchronizing member 302 through the auxiliary through hole V02, so that the second synchronizing member 302 is also subject to a resistance when rotating. Thus, the damping force provided by the torsion part 400 can be further improved.

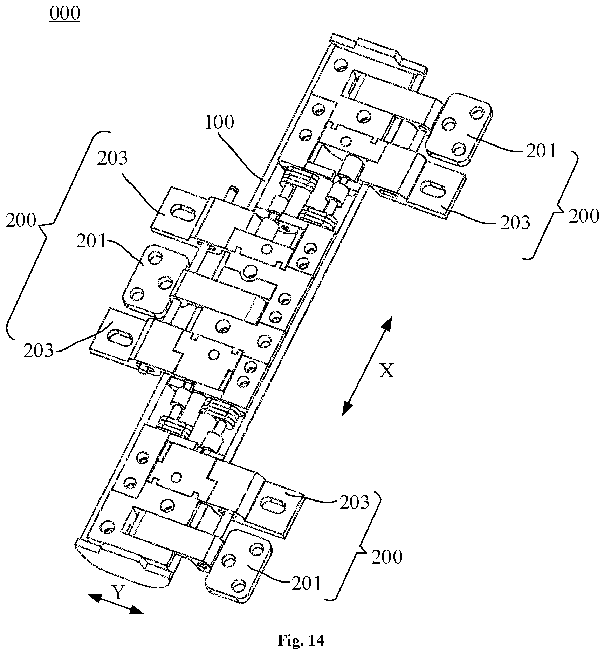

In some embodiments, as shown in FIG. 14, which is a schematic view of another hinge according to an embodiment of the present invention, the hinge 000 may include three flip parts 200, and each flip part 200 may include at least one first rotating member 201 and at least one rotating assembly 203. For example, in the three flip parts 200, two flip parts 200 located at both ends in the first direction X may each include one first rotating member 201 and one rotating assembly 203, and the two flip parts 200 are located on the same side of the supporting base 100. The flip part 200 located in the middle may include one first rotating member 201 and two rotating assemblies 203, and this flip part 200 may be located on the other side of the supporting base 100. Here, the first rotating member 201 in the flip part 200 located in the middle may be located between the two rotating assemblies 203 in this flip part 200, and the two rotating assemblies 203 in the flip part 200 located in the middle may be synchronously connected to the two rotating assemblies 203 in the two flip parts 200 located at both ends by means of the synchronizing mechanism 300, respectively.

In conclusion, the hinge according to the embodiments of the present invention includes the supporting base and the at least two flip parts. The flip part includes the first rotating member, and the first connecting portion connected to the first end of the first rotating member, and the part of the first connecting portion may be located in the first arc-shaped sliding groove in the supporting base. Since the first rotating member is connected to the supporting base through the first connecting portion, and the part of the first connecting portion may be located in the first arc-shaped sliding groove of the supporting base, the first connecting portion can be limited by the first arc-shaped sliding groove during the rotation of the first rotating member relative to the supporting base, so that the first rotating member connected to the first connecting portion will not fall off the supporting base, thus making the hinge more reliable, and hence improving the reliability of the foldable display device including the hinge.

Embodiments of the present invention also provide a foldable display device, and the foldable display device may be a foldable mobile phone, a foldable tablet computer or a foldable wearable device. Here, the foldable display device may include a flexible display panel, at least two housings, and the hinge in the above embodiments. The at least two housings in the foldable display device are connected by the hinge, and the flexible display panel in the foldable display device is arranged on and covers the at least two housings.

It should be noted that, in the drawings, the sizes of layers and regions may be exaggerated for clarity of illustration. It will also be understood that in case that an element or layer is referred to as being "on" another element or layer, it may be directly on the other element, or an intervening layer may be present. In addition, it will be understood that in case that an element or layer is referred to as being "beneath" another element or layer, it may be directly beneath the other element, or more than one intervening layer or element may be present. In addition, it may also be understood that in case that a layer or element is referred to as being "between" two layers or elements, it may be the only layer between the two layers or elements, or more than one intervening layer or element may also be present. Like numbers refer to like elements throughout the specification.

In the present invention, terms such as "first" and "second" are used herein for purposes of description and are not intended to indicate or imply relative importance. The term "a plurality of" means two or more than two, unless specified otherwise.

## Claims

1. A hinge (000), comprising:
a supporting base (100) extending in a first direction (X); and
at least two flip parts (200), each flip part (200) being rotatably connected to the supporting base (100), wherein the at least two flip parts (200) are configured to be distributed on two opposite sides of the supporting base (100) in a second direction (Y) in case that the hinge (000) is in an unfolded state, and the second direction (Y) intersects with the first direction (X),
wherein each of the at least two flip parts (200) comprises a first rotating member (201), and a first connecting portion (202) connected to a first end of the first rotating member (201); and
the supporting base (100) has a first arc-shaped sliding groove (C1), and a part of the first connecting portion (202) is located in the first arc-shaped sliding groove (C1).

2. The hinge (000) of claim 1, wherein the supporting base (100) further comprises a first hollowed-out groove (U1), and the first arc-shaped sliding groove (C1) is in communication with the first hollowed-out groove (U1); and
wherein the first end of the first rotating member (201) is located in the first hollowed-out groove (U1), and is rotatably connected to the supporting base (100) through the first connecting portion (202).

3. The hinge (000) of claim 1 or 2, wherein each of the at least two flip parts (200) further comprises a rotating assembly (203), a first end of the rotating assembly (203) is rotatably connected to the supporting base (100), and a second end of the rotating assembly (203) is slidably connected to a second end of the first rotating member (201).

4. The hinge (000) of claim 3, further comprising a synchronizing mechanism (300) connected to two flip parts (200) located on the two opposite sides of the supporting base (100), respectively,
wherein the synchronizing mechanism (300) comprises two first synchronizing members (301) rotatably connected to the first ends of the two rotating assemblies (203) respectively, and the two first synchronizing members (301) are connected to each other.

5. The hinge (000) of claim 4, wherein the first end of the rotating assembly (203) has a second rotating member (2031); and
wherein the supporting base (100) further comprises a second hollowed-out groove (U2), and a sliding portion (1011) located in the second hollowed-out groove (U2), and the second rotating member (2031) is located in the second hollowed-out groove (U2) and rotatably connected to the sliding portion (1011).

6. The hinge (000) of claim 5, wherein the first synchronizing member (301) comprises a first shaft (3011), and a roller (3012) fitted over the first shaft (3011) and fixedly connected to the first shaft (3011), and the roller (3012) is connected to the second rotating member (2031),
optionally, wherein the first synchronizing member (301) further comprises a first synchronizing wheel (3013) fitted over the first shaft (3011) and fixedly connected to the first shaft (3011); and
two first synchronizing wheels (3013) of the two first synchronizing members (301) are synchronously connected to each other.

7. The hinge (000) of claim 6, wherein the second rotating member (2031) comprises a second connecting portion (2031a) and a third connecting portion (203 1b), a surface of the second connecting portion (2031a) and a surface of the third connecting portion (2031b) enclose a second arc-shaped sliding groove (C2), and at least part of the sliding portion (1011) is located in the second arc-shaped sliding groove (C2).

8. The hinge (000) of claim 7, wherein the second connecting portion (2031a) comprises a first section (A1) and a second section (A2);
wherein the first section (A1) and the second section (A2) are arranged side by side, the first section (A1) is connected to the third connecting portion (2031b), and a surface of the first section (A1) and the surface of the third connecting portion (2031b) enclose the second arc-shaped sliding groove (C2); and
the roller (3012) is connected to the second section (A2), and the first section (A1) and the second section (A2) are configured to slide relative to the sliding portion (1011) along the second arc-shaped sliding groove (C2) to drive the roller (3012) to rotate.

9. The hinge (000) of claim 8, wherein a surface of the second connecting portion (2031a) facing the roller (3012) is an arc-shaped surface (S); and
wherein an arc-shaped surface (S) of the second section (A2) is frictionally connected to the roller (3012); or, an arc-shaped surface (S) of the second section (A2) has a meshing portion, and the second section (A2) is connected to the roller (3012) by the meshing portion,
optionally, wherein the arc-shaped surface (S) is an arc-shaped concave surface; and
the third connecting portion (2031b) comprises a body section (B1) and a protruding section (B2), the body section (B1) has a first arc-shaped convex surface, the protruding section (B2) has a second arc-shaped convex surface coaxial with the first arc-shaped convex surface, the body section (B1) is bridged on the second connecting portion (2031a), the first arc-shaped convex surface abuts against the arc-shaped concave surface, and the arc-shaped concave surface and the second arc-shaped convex surface enclose the second arc-shaped sliding groove (C2).

10. The hinge (000) of any one of claims 4 to 9, wherein the synchronizing mechanism (300) comprises a fixing member (303) located between the two rotating assemblies (203), and the fixing member (303) has a rolling part (304); and
wherein a side of the rotating assembly (203) adjacent to the fixing member (303) has a guide groove (U3), and a part of the rolling part (304) is located in the guide groove (U3),
optionally, the guide groove (U3) has a curve-shaped guiding direction.

11. The hinge (000) of claim 10, wherein the flip part (200) further comprises a connecting shaft (204) connected to the supporting base (100), and the connecting shaft (204) is connected to a side of the rotating assembly (203) adjacent to the fixing member (303); and
wherein the connecting shaft (204) is configured to slide in the first direction (X) relative to the supporting base (100), and/or, the rotating assembly (203) is configured to slide in the first direction (X) relative to the connecting shaft (204).

12. The hinge (000) of any one of claims 3 to 11, wherein the flip part (200) further comprises a fourth connecting portion (205) connected to the second end of the first rotating member (201), and an axial direction of the fourth connecting portion (205) is parallel to the first direction (X); and
the second end of the rotating assembly (203) has a sliding groove (L1), and an end of the fourth connecting portion (205) facing away from the first rotating member (201) is located in the sliding groove (L1) and slidably connected to the rotating assembly (203).

13. The hinge (000) of any one of claims 3 to 12, further comprising a torsion part (400) connected to the flip part (200), the torsion part (400) comprising one or more friction plates (401);
wherein the one or more friction plates (401) are arranged side by side in the first direction (X) in at least one of following positions:
between the first rotating member (201) and the supporting base (100) in any one of the flip parts (200);
between the rotating assembly (203) and the supporting base (100) in any one of the flip parts (200); and
between two adjacent flip parts (200);
optionally, wherein the torsion part (400) further comprises a transmission shaft (402) connected to the flip part (200), and the one or more friction plates (401) are fitted over the transmission shaft (402) in the first direction (X).

14. The hinge (000) of any one of claims 1 to 13, wherein the supporting base (100) comprises a protective shell (102) and a base body (101);
wherein the protective shell (102) is snap-fitted to the base body (101), and the base body (101) is rotatably connected to the flip part (200); and
wherein the at least two flip parts (200) are arranged side by side in the first direction (X).

15. A foldable display device, comprising a flexible display panel, at least two housings and a hinge (000) of any one of claims 1 to 14, wherein the at least two housings are connected to each other through the hinge (000), and the flexible display panel is arranged on and covers the at least two housings.
